# EUROPEAN PATENT APPLICATION

(11) **EP 2 575 168 A1**
(43) Date of publication of application: **03.04.2013**
(21) Application number: 12181981.7
(22) Date of filing: 28.08.2012
(51) Int. Cl.: H01L 23/40

(54) **Electronic device**

(30) Priority: 30.09.2011 JP 2011218289
(71) Applicant: FUJITSU LIMITED, Kawasaki-shi, Kanagawa 211-8588 (JP)
(72) Inventor: Fukuzono, Kenji, Kanagawa, 211-8588 (JP); Nakamura, Naoaki, Kanagawa, 211-8588 (JP)
(74) Representative: HOFFMANN EITLE

(57) **Abstract**

An electronic device includes: a first plate; a wiring board arranged on the first plate and configured to have a plurality of first terminals on a surface opposite to a surface facing the first plate; an electronic component arranged above the wiring board and configured to have a plurality of second terminals on a surface facing the wiring board; a connecting unit arranged between the wiring board and the electronic component and configured to electrically couple the first terminals and the second terminals; a second plate arranged on the electronic component; a fixing unit arranged in an area outside of an area where the electronic component is placed and configured to pressurize the first plate and the second plate; and a pressing unit arranged below the area where the electronic component is placed and configured to press the wiring board toward the electronic component.

## Description

### FIELD

The embodiments discussed herein are related to an electronic device that includes a heat-dissipating structure.

### BACKGROUND

In recent years, with CPUs (Central Processing Units) being increasingly refined and being made as many-core processors, the size of a semiconductor chip has increased, and the size of a semiconductor package having the semiconductor chip mounted thereon has also increased. Examples of a methodology of mounting a large-size semiconductor package on a main board (a wiring board) include a Ball Grid Array (BGA) mounting methodology, a Pin Grid Array (PGA) mounting methodology, and a Land Grid Array (LGA) mounting methodology.

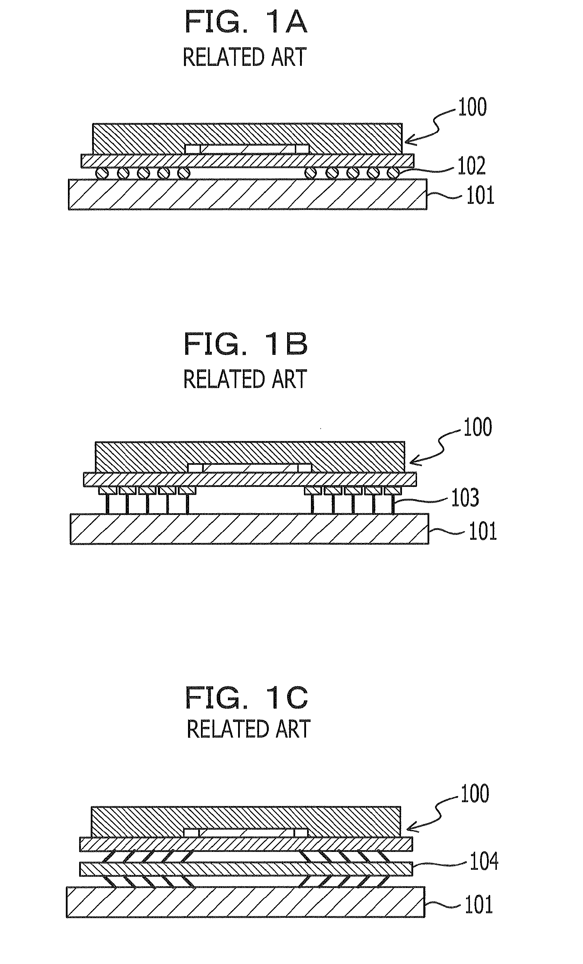

FIG. 1A is a diagram of an example of a connection structure between a semiconductor package 100 and a main board 101 that uses the BGA mounting methodology. In the BGA mounting methodology, solder balls 102 are placed on a lower surface (a back surface) of the semiconductor package 100, and the semiconductor package 100 and the main board 101 are coupled via the solder balls 102. FIG. 1B is a diagram of an example of a connection structure between the semiconductor package 100 and the main board 101 that uses the PGA mounting methodology. In the PGA mounting methodology, the semiconductor package 100 and the main board 101 are coupled via pins 103 provided on the lower surface of the semiconductor package 100. FIG. 1C is a diagram of an example of a connection structure between the semiconductor package 100 and the main board 101 that uses the LGA mounting methodology. In the LGA mounting methodology, an LGA socket 104 is placed between the semiconductor package 100 and the main board 101, and the semiconductor package 100 and the main board 101 are coupled via the LGA socket 104. A mounting methodology is selected based on the usage purpose in light of factors such as reliability, exchange frequency, and cost of a connecting unit between the semiconductor package and the main board.

By applying a load (pressure) to the semiconductor package to mount the semiconductor package on the main board, an electrical connection between the semiconductor package and the main board is obtained. In the semiconductor package mounted on the main board, the amount of heat of a semiconductor chip increases in response to high-speed operation of the semiconductor chip, and therefore the semiconductor package is desired to be cooled down. To increase a heat dissipation area, a cooling structure that is a heat dissipation device, such as a heat sink or a cooling unit, is mounted on the semiconductor package. With the cooling structure that is a heat dissipation device mounted on the semiconductor package, by applying a load to the heat dissipation device, the contact area with the semiconductor package is increased, thereby decreasing heat resistance.

To mount the semiconductor package on the main board or to mount the heat dissipation device on the semiconductor package, a load is applied. Thus, various ways of load application have been suggested. In one example of methodology, after the semiconductor package is mounted on the main board by applying a load to the semiconductor package, the heat dissipation device is mounted on the semiconductor package. In another example of methodology, a load when mounting the semiconductor package on the main board and a load with respect to the heat dissipation device are applied by the same loading device, thereby simplifying the structure

Since the size of a semiconductor package is increasing and the number of terminal electrodes of a semiconductor package tends to be increasing, the load to mount the semiconductor package on the main board is increasing. When the semiconductor package is interposed between the heat dissipation device and the main board, and the load is applied to the heat dissipation device and the main board in an area outside of the semiconductor package, the load applied to the center portion of the main board is light, and the load applied to a portion outside of the center portion of the main board is heavy. As such, when the load is applied to the main board partially in an unbalanced manner, warping may occur in the main board, the space between the semiconductor package and the main board may become nonuniform, and the electrical connection between the semiconductor package and the main board may become insufficient. It is desirable to suppress unevenness of a space between an electronic device and a wiring board when the electronic device is mounted on the wiring board.

According to embodiments of the present disclosure, unevenness of a space between the electronic device and the wiring board may be suppressed when the electronic device is mounted on the wiring board.

The followings are reference documents:
[Document 1] Japanese Unexamined Utility Model Registration Application Publication No. 5-1285,
[Document 2] Japanese Registered Utility Model No. 3102365, and
[Document 3] Japanese Laid-open Patent Publication No. 10-173091.

### SUMMARY

According to an aspect of the invention, an electronic device includes: a first plate; a wiring board arranged on the first plate and configured to have a plurality of first terminals on a surface opposite to a surface facing the first plate; an electronic component arranged above the wiring board and configured to have a plurality of second terminals on a surface facing the wiring board; a connecting unit arranged between the wiring board and the electronic component and configured to electrically couple the first terminals and the second terminals; a second plate arranged on the electronic component; a fixing unit arranged in an area outside of an area where the electronic component is placed and configured to pressurize the first plate and the second plate so that narrow a space between the first plate and the second plate; and a pressing unit arranged below the area where the electronic component is placed and configured to press the wiring board toward the electronic component.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1A is a diagram that illustrates an example of a connection structure between a semiconductor package and a main board with a BGA mounting methodology;
FIG. 1B is a diagram that illustrates an example of a connection structure between a semiconductor package and a main board with a PGA mounting methodology;
FIG. 1C is a diagram that illustrates an example of a connection structure between a semiconductor package and a main board with an LGA mounting methodology;
FIGs. 2A to FIG. 2E are diagrams each depicting a process of mounting a semiconductor package on a main board with the LGA mounting methodology in an electronic device according to a comparative example;
FIG. 3 is an image view of a space between the semiconductor package and the main board in the electronic device according to the comparative example;
FIG. 4 is a cross-sectional view of the electronic device according to the comparative example, depicting the case in which the semiconductor package is mounted on the main board with the BGA mounting methodology;
FIG. 5 is a cross-sectional view of an electronic device according to a first embodiment;
FIG. 6A is a cross-sectional view of a bolster plate provided with support shafts;
FIG. 6B is a top view of the bolster plate provided with the support shafts;
FIG. 7 is a cross-sectional view of the bolster plate and a main board;
FIG. 8A is a cross-sectional view of the electronic device according to the first embodiment when an LGA socket is placed on the main board and a semiconductor package is placed on the LGA socket;
FIG. 8B is a top view of the electronic device according to the first embodiment when the LGA socket is placed on the main board and the semiconductor package is placed on the LGA socket;
FIG. 9 is a cross-sectional view of the electronic device according to the first embodiment when a heat sink is placed on the semiconductor package;
FIG. 10 is a cross-sectional view of the electronic device according to the first embodiment when a spring and a nut are placed on the tip of each support shaft;
FIG. 11 is a cross-sectional view of the electronic device according to the first embodiment;
FIG. 12 is a cross-sectional view of the electronic device according to the first embodiment;
FIG. 13 is an image view of a space between the main board and the semiconductor package in the electronic device according to the first embodiment;
FIG. 14 is a cross-sectional view of the electronic device according to the first embodiment when a cover plate (a plate member) is provided between a bolster plate and the main board;
FIG. 15 is a cross-sectional view of an electronic device according to a second embodiment;
FIG. 16 is a top view of the electronic device according to the second embodiment when an LGA socket is placed on a main board and a semiconductor package is placed on the LGA socket;
FIG. 17 is a cross-sectional view of the electronic device according to the second embodiment when a cover plate (a plate member) is provided between a bolster plate and the main board;
FIG. 18 is a cross-sectional view of an electronic device according to a third embodiment;
FIG. 19 is a cross-sectional view of the electronic device according to the third embodiment when a cover plate (a plate member) is provided between a bolster plate and a main board;
FIG. 20 is a cross-sectional view of the electronic device according to the third embodiment when a support is provided for an outer peripheral portion of an upper surface of the bolster plate and a cover plate is placed on the support;
FIG. 21 is a cross-sectional view of an electronic device according to a fourth embodiment;
FIG. 22 is a cross-sectional view of the electronic device according to the fourth embodiment when a cover plate (a plate member) is provided between a bolster plate and a main board;
FIG. 23 is a cross-sectional view of the electronic device according to the fourth embodiment when a support is provided for an outer peripheral portion of an upper surface of the bolster plate and a cover plate is placed on the support;
FIG. 24 is a table depicting verification results of the electronic device according to the comparative example and the electronic devices according to the first, third, and fourth embodiments;
FIG. 25 is a cross-sectional view of the electronic device according to the first embodiment when the semiconductor package is mounted on the main board with the BGA mounting methodology; and
FIG. 26 is a cross-sectional view of the electronic device according to the first embodiment when the semiconductor package is mounted on the main board with the PGA mounting methodology.

### DESCRIPTION OF EMBODIMENTS

### [Comparative Example]

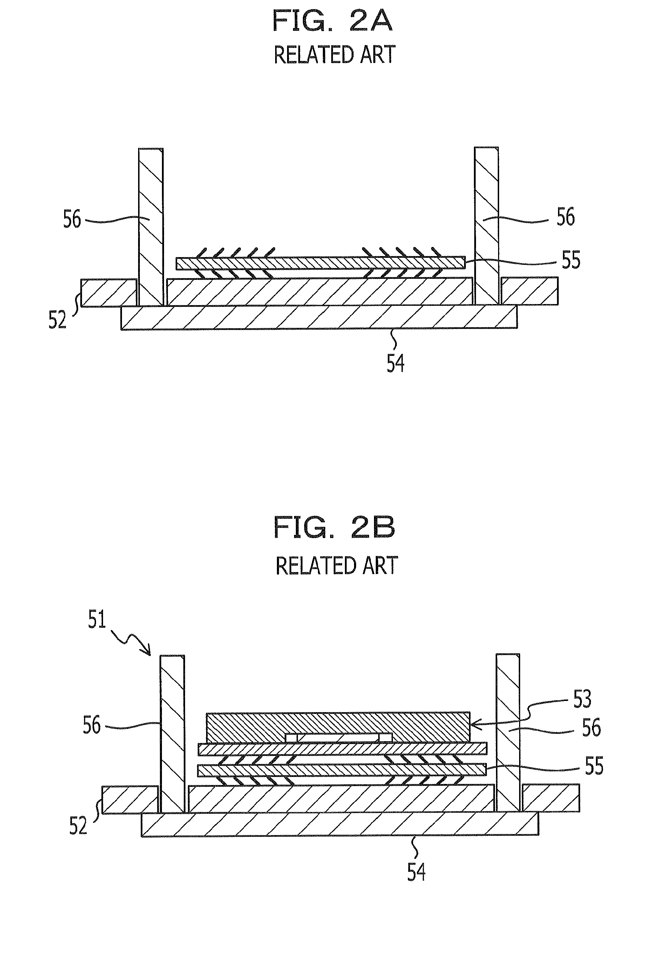

FIG. 2A to FIG. 2E are diagrams each depicting a process of mounting a semiconductor package 53 on a main board 52 with an LGA mounting methodology in an electronic device 51 according to a comparative example. As depicted in FIG. 2A, a bolster plate 54 is placed below a main board 52, and an LGA socket 55 is placed on the main board 52. The bolster plate 54 is provided with support shafts 56. The support shafts 56 each pass through a through hole provided in the main board 52 and protrude from the through hole provided in the main board 52.

As depicted in FIG. 2B, the semiconductor package 53 is placed on the LGA socket 55. Terminal electrodes of the semiconductor package 53 and pins (leads) of the LGA socket 55 are in contact with each other, and terminal electrodes of the main board 52 and pins (leads) of the LGA socket 55 are in contact with each other. With this, the terminal electrodes of the semiconductor package 53 and the terminal electrodes of the main board 52 are electrically coupled to each other via the LGA socket 55.

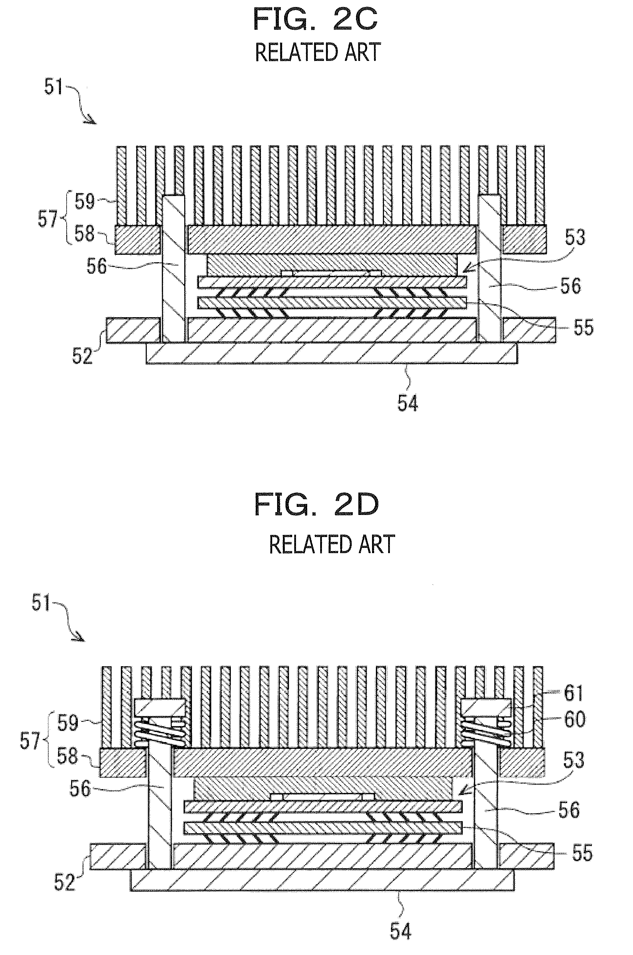

As depicted in FIG. 2C, a heat sink 57 is placed above the semiconductor package 53. The heat sink 57 has a base plate 58 and fins 59. The support shafts 56 each pass through a through hole provided in the base plate 58, and a tip of each support shaft 56 protrudes from the base plate 58. As depicted in FIG. 2D, a spring 60 and a nut 61 are placed on the tip of each support shaft 56.

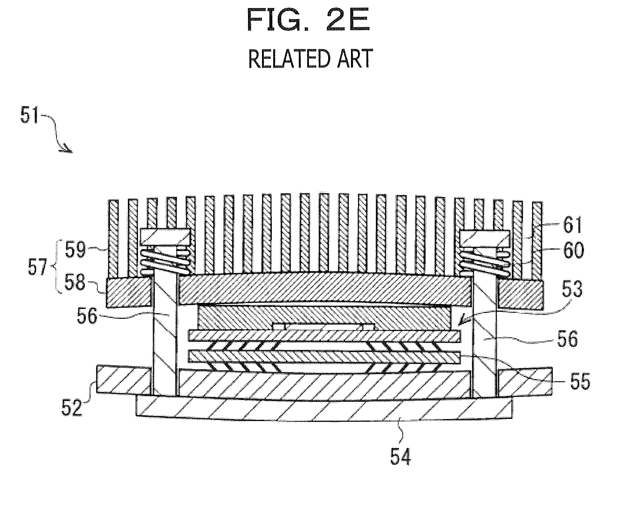

As depicted in FIG. 2E, by fastening the nut 61, the spring 60 is compressed. With the restoring force of the spring 60, a load (a pressure) is applied from the spring 60 to the base plate 58 in a direction in which the base plate 58 gets close to the bolster plate 54. In addition, with the restoring force of the spring 60, the support shaft 56 is pulled up, and thus a load (a pressure) is applied from the support shaft 56 to the bolster plate 54 in a direction in which the bolster plate 54 gets close to the base plate 58. Therefore, with the support shaft 56, the spring 60, and the nut 61, a load (a pressure) is applied to the bolster plate 54 and the base plate 58 so that a space between the bolster plate 54 and the base plate 58 is narrowed.

Since the support shafts 56 penetrate through the main board 52 and the base plate 58, the support shafts 56 are placed in an area outside of an area where the semiconductor package 53 is placed. Therefore, a load is applied to the bolster plate 54 and the base plate 58 in the area outside of the area where the semiconductor package 53 is placed. For this reason, the load applied to the center portion of the bolster plate 54 is relatively light, and the load applied to the portion outside the center portion of the bolster plate 54 is relatively heavy. The load applied to the center portion of the base plate 58 is relatively light, and the load applied to the portion outside the center portion of the base plate 58 is relatively heavy. As depicted in FIG. 2E, since the load is applied to the bolster plate 54 in the area outside of the area where the semiconductor package 53 is placed, the bolster plate 54 warps in a concave shape. In addition, as depicted in FIG. 2E, since the load is applied to the base plate 58 in the area outside of the area where the semiconductor package 53 is placed, the base plate 58 warps in a convex shape.

With the bolster plate 54 warping in a concave shape, the main board 52 placed above the bolster plate 54 also warps in a concave shape. For this reason, the space between the main board 52 and the LGA socket 55 becomes uneven. For example, the space between the main board 52 and the LGA socket 55 becomes large at a center portion of the LGA socket 55, and the space between the main board 52 and the LGA socket 55 becomes small at ends of the LGA socket 55. Therefore, a large difference occurs between a maximum value of the space between the main board 52 and the LGA socket 55 and a minimum value of the space between the main board 52 and the LGA socket 55. As a result, the contact between the terminal of the main board 52 and the pins of the LGA socket 55 becomes uneven, causing electrical contact between the main board 52 and the semiconductor package 53 via the LGA socket 55 to become insufficient and degrading reliability of the electronic device. For example, the terminal of the main board 52 and the pins of the LGA socket 55 may not be in contact with each other, or the pins of the LGA socket 55 may be bent.

With the base plate 58 warping in a convex shape, the semiconductor package 53 below the base plate 58 also warps in a convex shape. For this reason, the space between the semiconductor package 53 and the LGA socket 55 becomes uneven. For example, the space between the semiconductor package 53 and the LGA socket 55 becomes large at the center portion of the LGA socket 55, and the space between the semiconductor package 53 and the LGA socket 55 becomes small at the ends of the LGA socket 55. Therefore, a large difference occurs between a maximum value of the space between the semiconductor package 53 and the LGA socket 55 and a minimum value of the space between the semiconductor package 53 and the LGA socket 55. As a result, the contact between the terminal of the semiconductor package 53 and the pins of the LGA socket 55 becomes uneven, causing electrical contact between the main board 52 and the semiconductor package 53 via the LGA socket 55 to become insufficient and degrading reliability of the electronic device. For example, the terminal of the semiconductor package 53 and the pins of the LGA socket 55 may not be in contact with each other, or the pins of the LGA socket 55 may be bent.

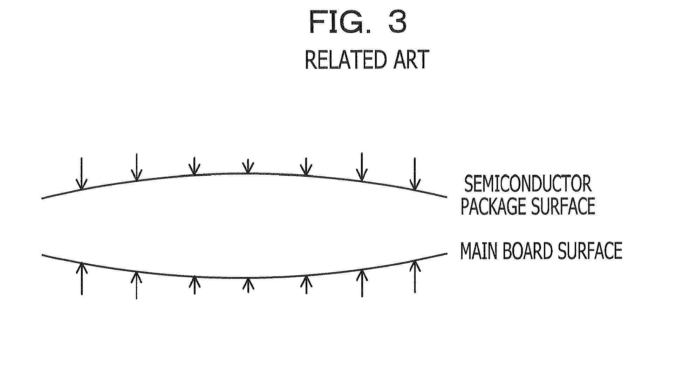

FIG. 3 is an image view of the space between the main board 52 and the semiconductor package 53 in the electronic device 51 according to the comparative example. As depicted in FIG. 3, the space is large between the center portion of the main board 52 and the center portion of the semiconductor package 53, and the space is small between the ends of the main board 52 and the ends of the semiconductor package 53. Arrows in FIG. 3 represent loads applied to the main board 52 and the semiconductor package 53. The length of each arrow in FIG. 3 represents the magnitude of a load applied to the main board 52 or the semiconductor package 53. Since the loads applied to the ends of the main board 52 and the ends of the semiconductor package 53 are large, warping at the ends of the main board 52 and the ends of the semiconductor package 53 is large, thereby decreasing the space between the ends of the main board 52 and the ends of the semiconductor package 53.

The size of the base plate 58 in a plane direction is larger than the size of the semiconductor package 53 in a plane direction. For this reason, the magnitude of warping of the base plate 58 is larger than the magnitude of warping of the semiconductor package 53, causing a space between the semiconductor package 53 and the base plate 58. When the semiconductor package 53 and the base plate 58 are directly in contact with each other, the center portion of the semiconductor package 53 and the center portion of the base plate 58 are not in contact with each other. As a result, heat transmission from the semiconductor package 53 to the heat sink 57 is decreased, and the heat dissipation capability of the semiconductor package 53 is degraded. In addition, when a thermally conductive material is interposed between the semiconductor package 53 and the base plate 58, the center portion of the thermally conductive material is not in contact with the semiconductor package 53 or the base plate 58. As a result, heat transmission from the semiconductor package 53 to the heat sink 57 is decreased, and the heat dissipation capability of the semiconductor package 53 is degraded.

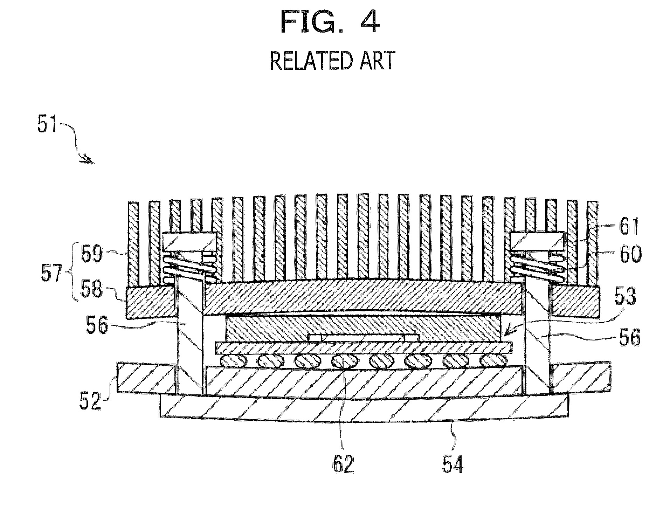

FIG. 4 is a cross-sectional view of the electronic device 51 according to the comparative example, depicting a case in which the semiconductor package 53 is mounted on the main board 52 with the BGA mounting methodology. When the semiconductor package 53 is mounted on the main board 52 with the BGA mounting methodology, the space between the main board 52 and the semiconductor package 53 is uneven. In addition, a space between the main board 52 and an outer peripheral portion of the semiconductor package 53 is narrow, and solder balls 62 placed on a lower surface (a back surface) of the semiconductor package 53 are deformed. In particular, since large loads are applied to corner portions of the semiconductor package 53, compressive stress concentrates on the solder balls 62 placed at the corner portions of the lower surface of the semiconductor package 53, and the solder balls 62 are gradually crushed. For this reason, due to creep deformation of the solder balls 62 placed at the corner portions of the lower surface of the semiconductor package 53, the electrical connection between the main board 52 and the semiconductor package 53 becomes insufficient, thereby degrading reliability of the electronic device.

An electronic device and electronic device manufacturing method according to embodiments to solve the problems described above are described below with reference to the drawings. The structure of each of the following embodiments is merely an example, and the electronic device and electronic device manufacturing method according to the embodiments are not restricted to the structures of the embodiments.

### [First Embodiment]

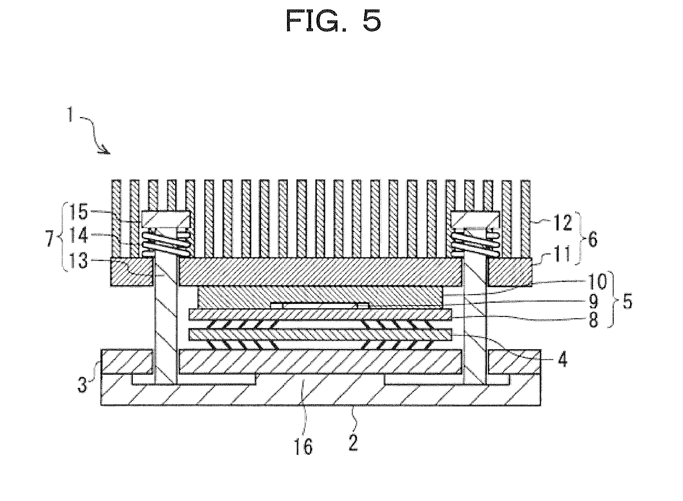

FIG. 5 is a cross-sectional view of an electronic device 1 according to a first embodiment. The electronic device 1 according to the first embodiment has a bolster plate 2, a main board 3, an LGA socket 4, a semiconductor package 5, a heat sink 6, and fixing units 7. The bolster plate 2 is an example of a first plate. The main board 3 is an example of a wiring board. The LGA socket 4 is an example of a connecting unit. The semiconductor package 5 is an example of an electronic component. The main board 3 is placed above the bolster plate 2. The LGA socket 4 is placed on the main board 3. The semiconductor package 5 is placed on the LGA socket 4. The heat sink 6 is placed on the semiconductor package 5. The semiconductor package 5 has a package substrate 8, a semiconductor chip (a semiconductor element) 9, and a heat spreader 10. The heat sink 6 has a base plate 11 and fins 12. The base plate 11 is an example of a second plate. Each of the fixing units 7 has a support shaft 13, a spring 14, and a nut 15. The fixing unit 7 is placed in an area outside of an area where the semiconductor package 5 is placed. A projection 16 is provided on an upper surface of the bolster plate 2. The projection 16 is an example of a pressing unit. The upper surface of the bolster plate 2 is a surface where the main board 3 is placed. When a load (a pressure) is applied by the fixing unit 7 to the bolster plate 2 and the base plate 11 so as to narrow a space between the bolster plate 2 and the base plate 11, the projection 16 presses the main board 3 toward the semiconductor package 5. That is, the projection 16 presses the main board 3 in a direction of the area where the semiconductor package 5 is placed. The projection 16 is provided below the area where the semiconductor package 5 is placed. As a result, with the projection 16 pressing the main board 3 toward the semiconductor package 5, unevenness of the space between the main board 3 and the semiconductor package 5 is suppressed.

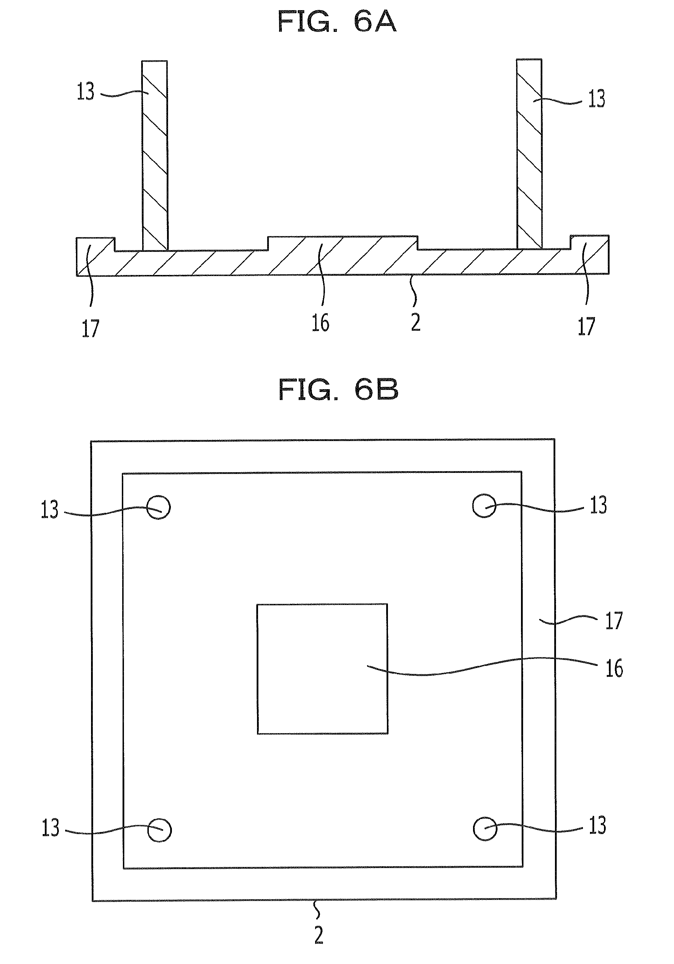

With reference to FIG. 6A to FIG. 12, description is made to a process of mounting the semiconductor package 5 on the main board 3 with the LGA mounting methodology in the electronic device 1 according to the first embodiment. FIG. 6A is a cross-sectional view of the bolster plate 2 that is provided with the support shafts 13. For example, stainless steel may be used as the material of the bolster plate 2 and the support shafts 13. With each support shaft 13 inserted in a shaft hole provided in the bolster plate 2, the support shaft 13 may be fixed to the bolster plate 2. Alternatively, a through hole penetrating through the bolster plate 2 may be provided in the bolster plate 2, and the support shaft 13 may be inserted through the through hole and fixed with a fixture from a lower surface (a back surface) of the bolster plate 2. The lower surface of the bolster plate 2 is the surface opposite to the surface that faces the main board 3.

FIG. 6B is a top view of the bolster plate 2 provided with the support shafts 13. As depicted in FIG. 6A and FIG. 6B, on the upper surface of the bolster plate 2, the projection 16 is provided at the center portion of the bolster plate 2, and a support 17 is provided in an outer peripheral portion of the bolster plate 2. Therefore, a step is formed between the center portion and the outer peripheral portion of the bolster plate 2. For example, stainless steel may be used as the material of the projection 16 and the support 17. The projection 16 and the support 17 may have a cubic shape or a columnar shape. The projection 16 and the support 17 have the same height. In the first embodiment, a portion of the upper surface of the bolster plate 2 positioned between the projection 16 and the support 17 is referred to as the base surface of the bolster plate 2. The support shafts 13 are provided on the base surface of the bolster plate 2.

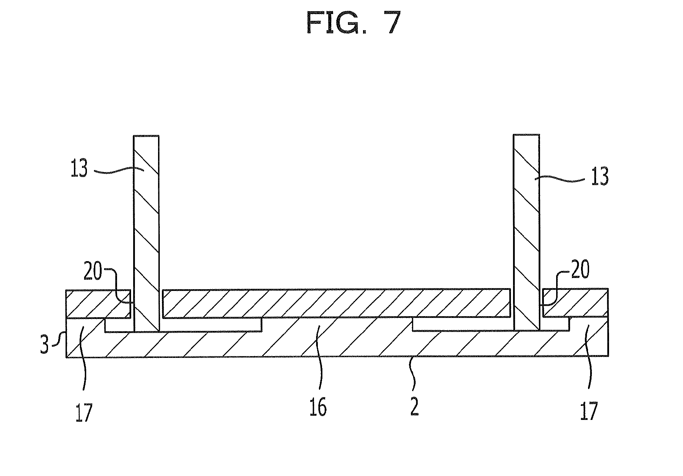

As depicted in FIG. 7, the main board 3 is placed on the bolster plate 2. For example, a resin substrate may be used as a material of the main board 3. The support shafts 13 each pass through a through hole 20 provided in the main board 3 and protrude from the through hole 20 provided in the main board 3. Note that the support shafts 13 may be fixed to the bolster plate 2 by placing the main board 3 on the bolster plate 2, inserting the support shafts 13 in the through holes 20 provided in the main board 3, and then inserting the support shafts 13 in shaft holes provided in the bolster plate 2.

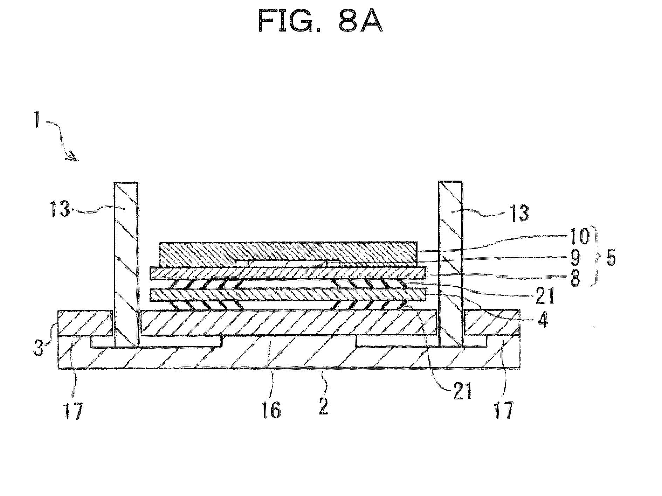

As depicted in FIG. 8A, the LGA socket 4 is placed on the main board 3, and the semiconductor package 5 is placed on the LGA socket 4. On an upper surface of the main board 3, a plurality of terminal electrodes are provided. The upper surface of the main board 3 is a surface where the semiconductor package 5 is placed and is the surface opposite to the surface facing the bolster plate 2. The LGA socket 4 has pins (leads) 21 as connection terminals. The pins 21 of the LGA socket 4 penetrate through the LGA socket 4 and protrude from the upper and lower surfaces of the LGA socket 4. A semiconductor chip 9 is provided on the package substrate 8. The semiconductor chip 9 is electrically coupled to (mounted on) the package substrate 8 with, for example, a flip chip connection. The heat spreader 10 is provided on the package substrate 8 so as to cover the upper surface and side surfaces of the semiconductor chip 9. For example, a metal such as copper may be used as a material of the heat spreader 10. On a lower surface of the package substrate 8, a plurality of terminal electrodes are provided. That is, a plurality of terminal electrodes are provided on the lower surface (the back surface) of the semiconductor package 5. The lower surface of the semiconductor package 5 is the surface facing the main board 3 and the surface opposite to a surface where the heat sink 6 is placed.

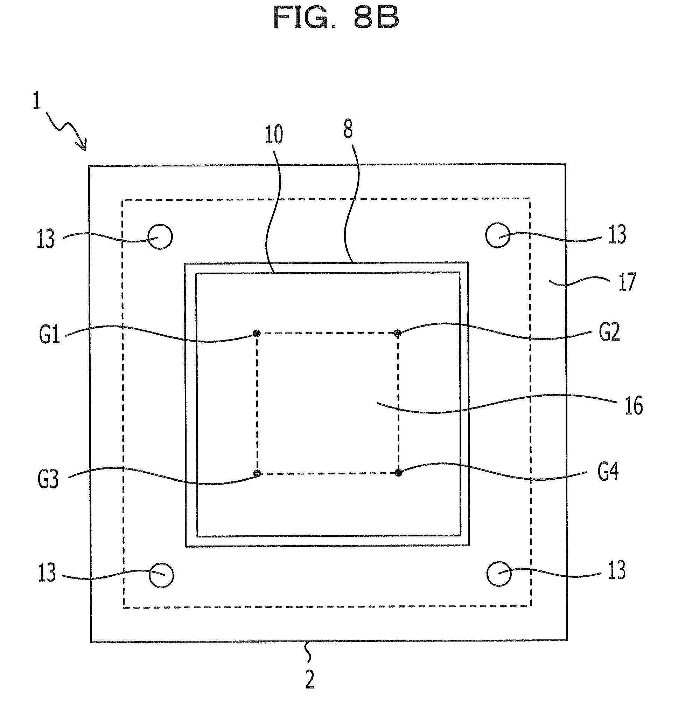

The terminal electrodes of the main board 3 and the pins 21 of the LGA socket 4 are in contact with each other, and the terminal electrodes of the semiconductor package 5 and the pins 21 of the LGA socket 4 are in contact with each other. Therefore, the pins 21 of the LGA socket 4 electrically couple the terminal electrodes of the main board 3 and the terminal electrodes of the semiconductor package 5. As a result, the main board 3 and the semiconductor package 5 are electrically coupled to each other via the LGA socket 4. FIG. 8B is a top view of the electronic device 1 according to the first embodiment when the LGA socket 4 is placed on the main board 3 and the semiconductor package 5 is placed on the LGA socket 4. Here, the position where the projection 16 is placed is described. The area where the LGA socket 4 is placed is divided by the number of support shafts 13 to be placed. When the number of support shafts 13 to be placed is four, the area where the LGA socket 4 is placed is divided into four. Then, the projection 16 is provided on the bolster plate 2 so that the outer peripheral portion of the projection 16 passes center of gravity points (G1 to G4 in FIG. 8B) of the respective divided areas. For example, when the projection 16 has a cubic shape, the projection 16 is provided on the bolster plate 2 so that four corners of the upper surface of the projection 16 pass the center of gravity points of the respective divided areas. However, the position where the projection 16 is placed described above is merely an example, and the projection 16 may be provided at a position other than the above.

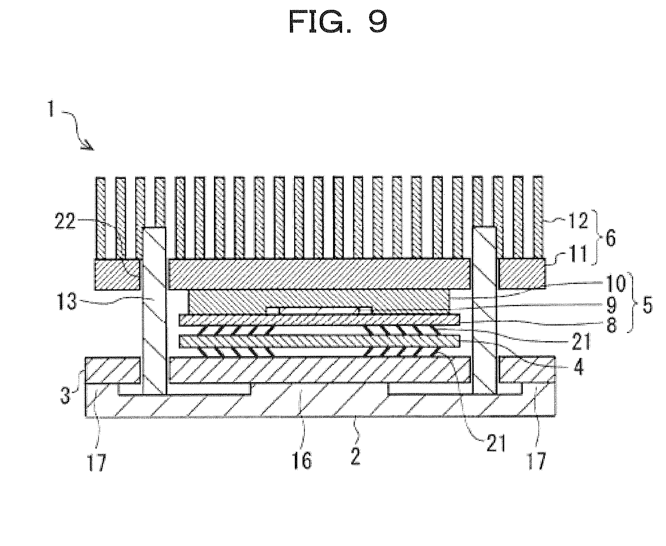

As depicted in FIG. 9, the heat sink 6 is placed on the semiconductor package 5. For example, aluminum, copper, aluminum nitride, or the like may be used as the material of the base plate 11 and the fins 12. Heat occurring at the semiconductor chip 9 is transmitted via the heat spreader 10 to the heat sink 6 and is dissipated by the heat sink 6. The support shafts 13 each pass the through hole 22 provided in the base plate 11, and the tip of each support shaft 13 protrudes from the base plate 11. A thermally conductive material such as aluminum, copper, or aluminum nitride may be interposed between the semiconductor package 5 and the base plate 11.

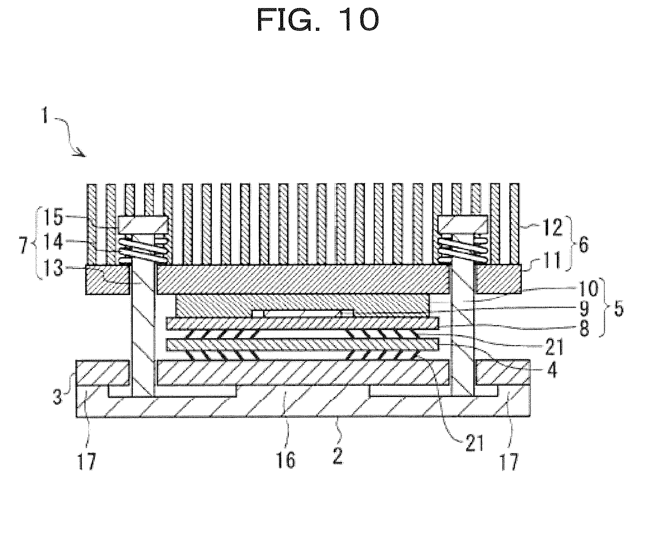

As depicted in FIG. 10, a spring 14 and a nut 15 are placed on the tip of each support shaft 13. The spring 14 is compressed by fastening the nut 15. With the restoring force of the spring 14, a load (a pressure) is applied from the spring 14 to the base plate 11 in a direction in which the base plate 11 gets close to the bolster plate 2. In addition, with the restoring force of the spring 14, the support shaft 13 is pulled up, and thus a load (a pressure) is applied from the support shaft 13 to the bolster plate 2 in a direction in which the bolster plate 2 gets close to the base plate 11. Therefore, with the support shaft 13, the spring 14, and the nut 15, a load (a pressure) is applied to the bolster plate 2 and the base plate 11 so that a space between the bolster plate 2 and the base plate 11 may be narrowed.

Since the support shafts 13 penetrate through the main board 3 and the base plate 11, the support shafts 13 are provided at the outer peripheral portion of the bolster plate 2. That is, the support shafts 13 are placed in an area outside an area where the semiconductor package 5 is placed. Therefore, a load is applied to the base plate 11 in the area outside the area where the semiconductor package 5 is placed. For this reason, the load applied to a center portion of the base plate 11 is light, and the load applied to a portion outside the center portion of the base plate 11 is heavier. When the load is applied to the base plate 11 in the area outside of the area where the semiconductor package 5 is placed, the base plate 11 warps in a convex shape.

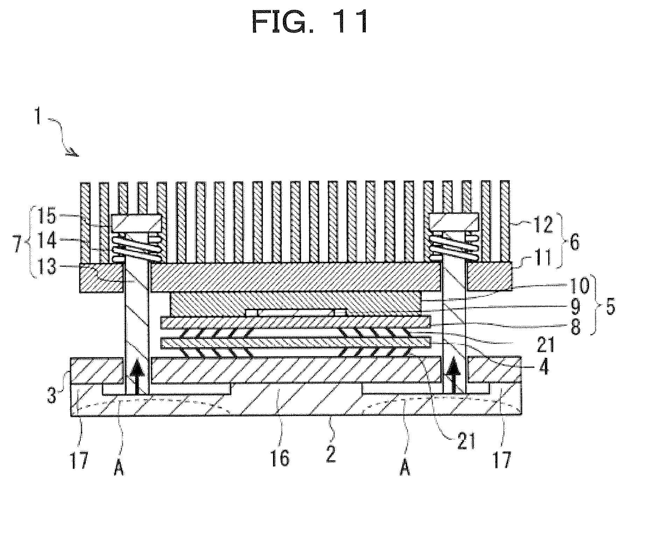

As depicted in FIG. 10, the projection 16 and the support 17 are in contact with the lower surface (the back surface) of the main board 3, and the base surface of the bolster plate 2 is not in contact with the lower surface of the main board 3. The lower surface of the main board 3 is the surface facing the bolster plate 2 and is the surface opposite to the surface where the semiconductor package 5 is placed. As depicted in FIG. 10, a space is formed between the bolster plate 2 and the main board 3 so as to surround each support shaft 13. Also as depicted in FIG. 10, a space is formed between the bolster plate 2 and the main board 3 with the space surrounding the projection 16. As a result, when a load is applied from the support shafts 13 to the bolster plate 2, portions indicated by dotted lines A in FIG. 11 of the bolster plate 2 first warp, and a load is applied from the projection 16 and the support 17 to the main board 3. That is, the projection 16 is pressed onto the center portion of the lower surface of the main board 3 toward the semiconductor package 5. Then, with the projection 16 pressing the main board 3 toward the semiconductor package 5, a load is applied from the projection 16 to the center portion of the lower surface of the main board 3. In addition, the support 17 is pressed onto the outer peripheral portion of the lower surface of the main board 3 toward the semiconductor package 5. Then, with the support 17 pressing the main board 3 toward the semiconductor package 5, a load is applied from the support 17 to the outer peripheral portion of the lower surface of the main board 3. With the load being applied from the projection 16 and the support 17 to the main board 3, a stable electrical connection may be obtained between the main board 3 and the semiconductor package 5.

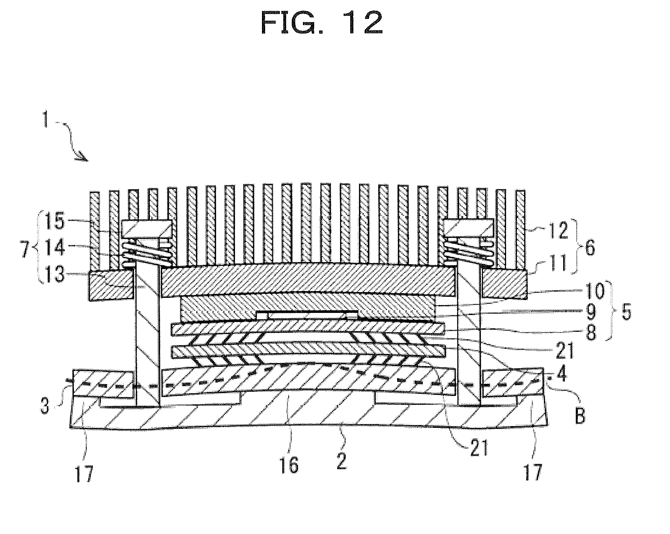

With the load being applied from the projection 16 to the center portion of the lower surface of the main board 3, as depicted in FIG. 12, the center portion of the main board 3 warps in a convex shape. That is, the center portion of the main board 3 bulges toward the semiconductor package 5 (in the direction of the area where the semiconductor package 5 is placed). In addition, with the load being applied from the support 17 to the lower surface of the main board 3, as depicted in FIG. 12, the outer peripheral portion of the main board 3 bulges toward the semiconductor package 5 (in the direction of the area where the semiconductor package 5 is placed). A dotted line B in FIG. 12 represents a deformed image of the main board 3.

The LGA socket 4 and the semiconductor package 5 are placed at the center portion of the upper surface of the main board 3. For this reason, with the center portion of the main board 3 warping in a convex shape, the LGA socket 4 and the semiconductor package 5 warp in a convex shape. With the center portion of the main board 3 warping in a convex shape and the LGA socket 4 also warping in a convex shape, unevenness of the space between the main board 3 and the LGA socket 4 may be suppressed. In addition, with the LGA socket 4 warping in a convex shape and the semiconductor package 5 also warping in a convex shape, unevenness of the space between the LGA socket 4 and the semiconductor package 5 may be suppressed. Therefore, unevenness of the space between the main board 3 and the semiconductor package 5 is suppressed. As a result, the terminal electrodes of the main board 3 and the pins 21 of the LGA socket 4 are uniformly in contact with each other, and the pins 21 of the LGA socket 4 and the terminal electrodes of the semiconductor package 5 are uniformly in contact with each other, thereby maintaining an electrical connection between the main board 3 and the semiconductor package 5 via the LGA socket 4.

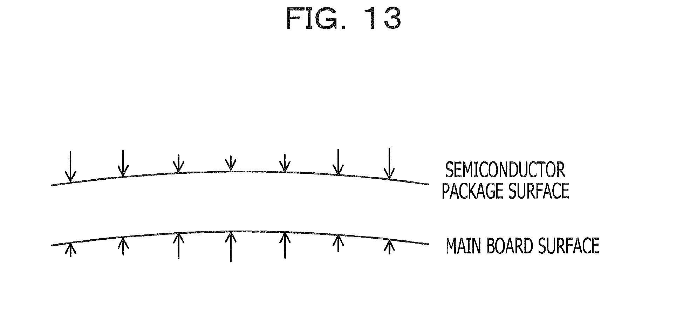

FIG. 13 is an image view of the space between the main board 3 and the semiconductor package 5 in the electronic device 1 according to the first embodiment. As depicted in FIG. 13, unevenness of the space between the main board 3 and the semiconductor package 5 is suppressed. Arrows in FIG. 13 represent loads applied to the main board 3 and the semiconductor package 5. The length of each arrow in FIG. 13 represents the magnitude of the load applied to the main board 3 or the semiconductor package 5.

In the electronic device 1 according to the first embodiment, since the load is applied from the projection 16 to the center portion of the lower surface of the main board 3, warping of the semiconductor package 5 is larger, compared with the electronic device 51 according to the comparative example. Therefore, according to the electronic device 1 of the first embodiment, unevenness of the space between the semiconductor package 5 and the base plate 11 may be suppressed. That is, according to the electronic device 1 of the first embodiment, the ratio of contact between the semiconductor package 5 and the base plate 11 is increased. As a result, heat transmission from the semiconductor package 5 to the heat sink 6 may be improved, and heat dissipation capability of the semiconductor package 5 may be improved. Also, when a thermally conductive material is interposed between the semiconductor package 5 and the base plate 11, the ratio of contact between the semiconductor package 5 and the thermally conductive material and the ratio of contact between the base plate 11 and the thermally conductive material may be increased. As a result, heat transmission from the semiconductor package 5 to the heat sink 6 may be improved, and heat dissipation capability of the semiconductor package 5 may be improved.

In the electronic device 1 according to the first embodiment, the projection 16 and the support 17 are provided as part of the bolster plate 2, and a load is applied from the projection 16 and the support 17 to the main board 3, thereby mounting the semiconductor package 5 on the main board 3. With only a load applied from the projection 16 to the main board 3, an electrical connection between the semiconductor package 5 and the main board 3 may be insufficient. In this case, the projection 16 and the support 17 are provided as part of the bolster plate 2, and a load is applied from the projection 16 and the support 17 to the main board 3. Thereby, a stable electrical connection between the main board 3 and the semiconductor package 5 may be obtained. However, if a stable electrical connection between the main board 3 and the semiconductor package 5 may be obtained by applying a load from the projection 16 to the main board 3, not providing the support 17 as part of the bolster plate 2 may be an option.

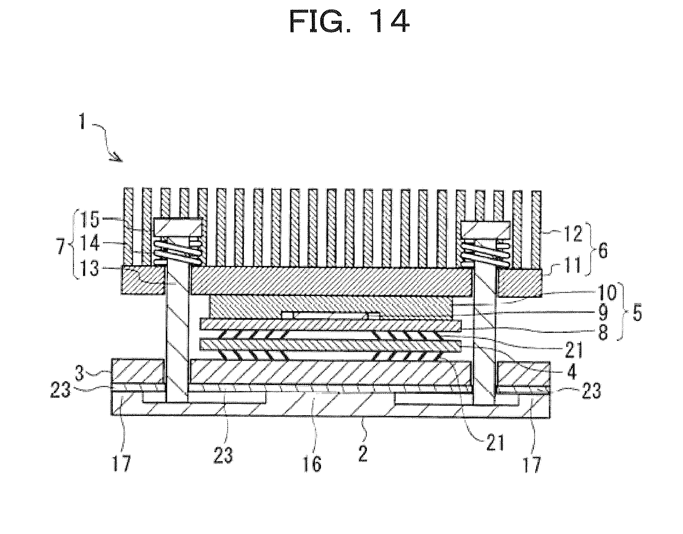

In the electronic device 1 according to the first embodiment, a cover plate (a plate member) 23 may be provided between the bolster plate 2 and the main board 3 as depicted in FIG. 14. That is, the cover plate 23 may be placed on the projection 16 and the support 17. The cover plate 23 may be laminated to the lower surface of the bolster plate 2 with an adhesive. For the cover plate 23, a material with a stiffness higher than that of the main board 3 is preferably used. As the material of the cover plate 23, stainless steel may be used. Because the main board 3 tends to be made thinner, the stiffness of the main board 3 declines. When the main board 3 has a low stiffness, by applying a load from the projection 16 and the support 17 to the main board 3, the main board 3 may be bent. By providing the cover plate 23 between the bolster plate 2 and the main board 3, partial concentration of the load applied from the projection 16 and the support 17 to the main board 3 is suppressed, and bending of the main board 3 may be suppressed.

### [Second Embodiment]

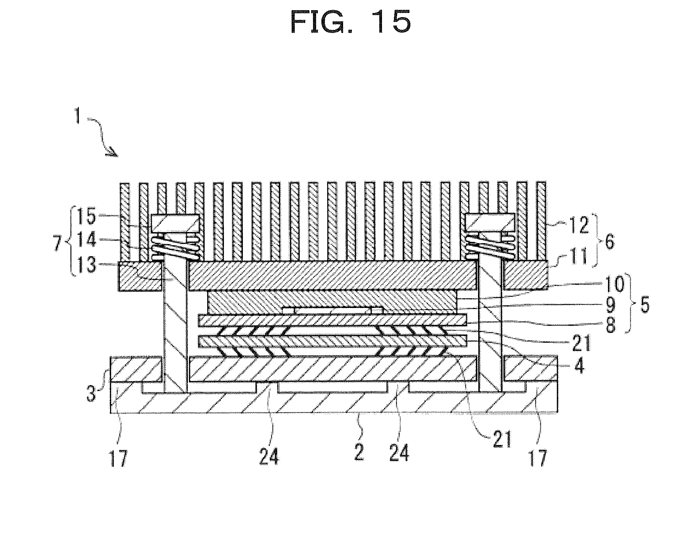

FIG. 15 is a cross-sectional view of the electronic device 1 according to a second embodiment. Note that elements identical to those in the first embodiment are each provided with the same reference numeral as that of the first embodiment and are not described herein. In the electronic device 1 according to the second embodiment, a plurality of projections 24 are provided on the upper surface of the bolster plate 2. The projections 24 are an example of the pressing unit. As a material of the projections 24, stainless steel may be used. Each of the projections 24 may be in a cubic shape or a columnar shape. The projections 24 and the support 17 have the same height. When a load (a pressure) is applied by the fixing unit 7 to the bolster plate 2 and the base plate 11 so as to narrow the space between the bolster plate 2 and the base plate 11, the plurality of projections 24 press the main board 3 toward the semiconductor package 5. That is, the plurality of projections 24 press the main board 3 in the direction of the area where the semiconductor package 5 is placed. The plurality of projections 24 are provided below the area where the semiconductor package 5 is placed. For this reason, with the plurality of projections 24 pressing the main board 3 toward the semiconductor package 5, unevenness of the space between the main board 3 and the semiconductor package 5 may be suppressed. As a result, the terminal electrodes of the main board 3 and the pins 21 of the LGA socket 4 may be uniformly in contact with each other. In addition, with the pins 21 of the LGA socket 4 and the terminal electrodes of the semiconductor package 5 being uniformly in contact with each other, an electrical connection between the main board 3 and the semiconductor package 5 via the LGA socket 4 may be maintained.

In the electronic device 1 according to the second embodiment, since the load is applied from the plurality of projections 24 to the center portion of the lower surface of the main board 3, warping of the semiconductor package 5 is larger, compared with the electronic device 51 according to the comparative example. Therefore, according to the electronic device 1 of the second embodiment, unevenness of the space between the semiconductor package 5 and the base plate 11 may be suppressed. That is, according to the electronic device 1 of the second embodiment, the ratio of contact between the semiconductor package 5 and the base plate 11 may be increased. As a result, heat transmission from the semiconductor package 5 to the heat sink 6 may be improved, and heat dissipation capability of the semiconductor package 5 may be improved. In addition, when a thermally conductive material is interposed between the semiconductor package 5 and the base plate 11, the ratio of contact between the semiconductor package 5 and the thermally conductive material and the ratio of contact between the base plate 11 and the thermally conductive material may be increased. As a result, heat transmission from the semiconductor package 5 to the heat sink 6 is improved, and heat dissipation capability of the semiconductor package 5 may be improved.

In the electronic device 1 according to the second embodiment, the support 17 and the plurality of projections 24 are provided as part of the bolster plate 2, and a load is applied from the support 17 and the plurality of projections 24 to the main board 3, thereby mounting the semiconductor package 5 on the main board 3. With only a load being applied from the plurality of projections 24 to the main board 3, an electrical connection between the main board 3 and the semiconductor package 5 may be insufficient. In this case, the support 17 and the plurality of projections 24 are provided as part of the bolster plate 2, and a load is applied from the support 17 and the plurality of projections 24 to the main board 3. With this, a stable electrical connection between the main board 3 and the semiconductor package 5 may be obtained. However, if a stable electrical connection between the main board 3 and the semiconductor package 5 may be obtained by applying a load from the plurality of projections 24 to the main board 3, not providing the support 17 as part of the bolster plate 2 is an option.

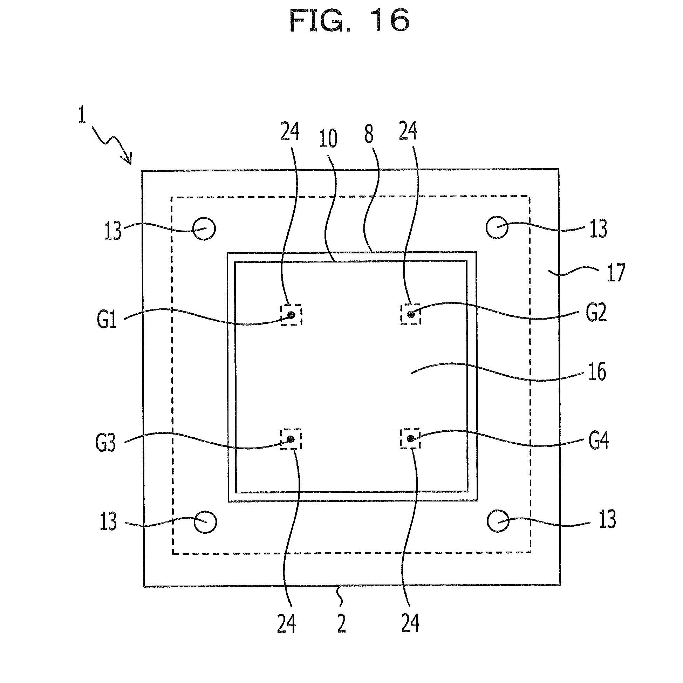

With reference to FIG. 16, the position where the projections 24 are placed is described. FIG. 16 is a top view of the electronic device 1 according to the second embodiment when the LGA socket 4 is placed on the main board 3 and the semiconductor package 5 is placed on the LGA socket 4. The area where the LGA socket 4 is placed is divided by the number of support shafts 13 to be placed. When the number of support shafts 13 to be placed is four, the area where the LGA socket 4 is placed is divided into four. Then, the plurality of projections 24 (four projections 24 in FIG. 16) are provided on the bolster plate 2 so that the plurality of projections 24 superpose center of gravity points (G1 to G4 in FIG. 16) of the respective divided areas. However, the positions where the plurality of projections 24 are placed described above are merely an example, and the projections 24 may be provided at positions other than the above. In addition, the number of projections 24 to be placed is not restricted to four, and may be a different number.

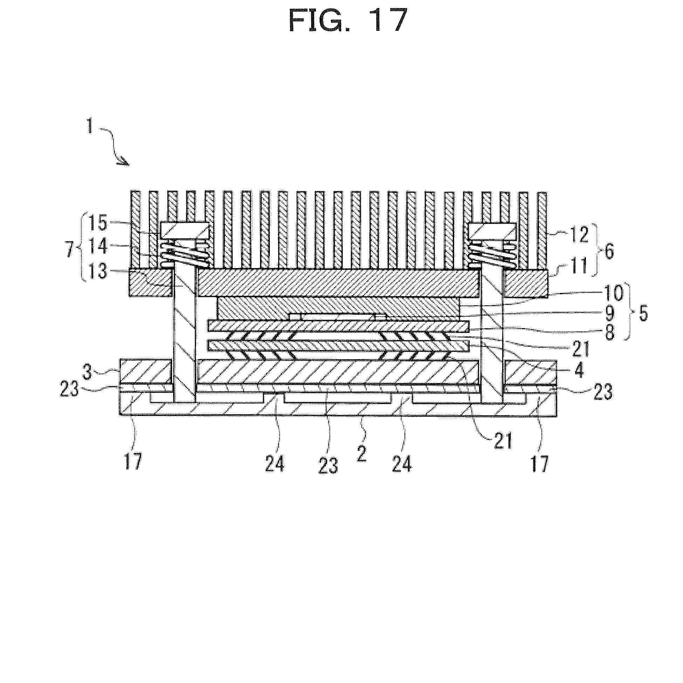

In the electronic device 1 according to the second embodiment, the cover plate (the plate member) 23 may be provided between the bolster plate 2 and the main board 3 as depicted in FIG. 17. That is, the cover plate 23 may be placed on the support 17 and the plurality of projections 24. When the main board 3 has a low stiffness, by applying a load from the support 17 and the plurality of projections 24 to the main board 3, the main board 3 may be bent. By providing the cover plate 23 between the bolster plate 2 and the main board 3, partial concentration of the load applied from the support 17 and the plurality of projections 24 to the main board 3 may be suppressed, and bending of the main board 3 may be suppressed.

### [Third Embodiment]

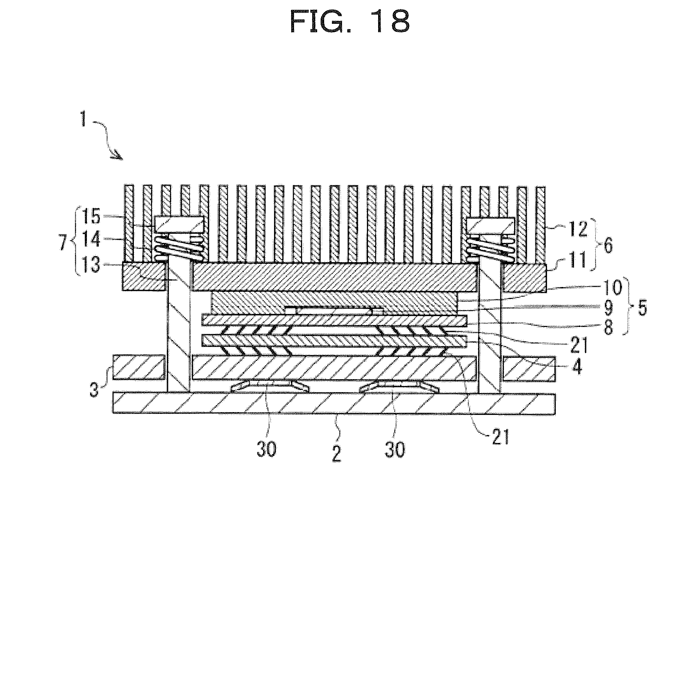

FIG. 18 is a cross-sectional view of the electronic device 1 according to a third embodiment. Elements identical to those in the first embodiment are each provided with the same reference numeral as that of the first embodiment and are not described herein. In the electronic device 1 according to the third embodiment, a plurality of disc springs 30 are provided on the upper surface of the bolster plate 2. The disc springs 30 are an example of the pressing unit. The disc springs 30 are elastic bodies capable of obtaining a large restoring force with a small compression amount. The lower surface of the main board 3 and an upper surface of each disc spring 30 are in contact with each other. When a load (a pressure) is applied by the fixing unit 7 to the bolster plate 2 and the base plate 11 so as to narrow the space between the bolster plate 2 and the base plate 11, the plurality of disc springs 30 press the main board 3 toward the semiconductor package 5. That is, the plurality of disc springs 30 press the main board 3 in the direction of the area where the semiconductor package 5 is placed. The plurality of disc springs 30 are provided below the area where the semiconductor package 5 is placed. Thereby, with the plurality of disc springs 30 pressing the main board 3 toward the semiconductor package 5, unevenness of the space between the main board 3 and the semiconductor package 5 may be suppressed. As a result, the terminal electrodes of the main board 3 and the pins 21 of the LGA socket 4 may be uniformly in contact with each other, and the pins 21 of the LGA socket 4 and the terminal electrodes of the semiconductor package 5 may be uniformly in contact with each other, thereby maintaining an electrical connection between the main board 3 and the semiconductor package 5 via the LGA socket 4.

In the electronic device 1 according to the third embodiment, since the load is applied from the plurality of disc springs 30 to the center portion of the lower surface of the main board 3, warping of the semiconductor package 5 is larger, compared with the electronic device 51 according to the comparative example. Therefore, according to the electronic device 1 of the third embodiment, unevenness of the space between the semiconductor package 5 and the base plate 11 may be suppressed. That is, according to the electronic device 1 of the third embodiment, the ratio of contact between the semiconductor package 5 and the base plate 11 may be increased. As a result, heat transmission from the semiconductor package 5 to the heat sink 6 may be improved, and heat dissipation capability of the semiconductor package 5 may be improved. In addition, when a thermally conductive material is interposed between the semiconductor package 5 and the base plate 11, the ratio of contact between the semiconductor package 5 and the thermally conductive material and the ratio of contact between the base plate 11 and the thermally conductive material may be increased. As a result, heat transmission from the semiconductor package 5 to the heat sink 6 may be improved, and heat dissipation capability of the semiconductor package 5 may be improved.

In the electronic device 1 according to the third embodiment, the plurality of disc springs 30 are provided on the bolster plate 2 to cause the lower surface of the main board 3 and the upper surface of each of the disc springs 30 to be in contact with each other. In the electronic device 1 according to the third embodiment, by applying a load from the plurality of disc springs 30 to the main board 3, the semiconductor package 5 is mounted on the main board 3. With the restoring force of the disc springs 30, the main board 3 may be efficiently pressed toward the semiconductor package 5. Therefore, with the plurality of disc springs 30 being provided on the bolster plate 2 and a load being applied from the plurality of disc springs 30 to the main board 3, a stable electrical connection between the main board 3 and the semiconductor package 5 may be obtained.

With the plurality of disc springs 30 being provided to the bolster plate 2, the main board 3 may be efficiently pressed toward the semiconductor package 5. Therefore, the support 17 may be omitted from the outer peripheral portion of the upper surface of the bolster plate 2. However, it is possible to provide the plurality of disc springs 30 to the bolster plate 2 and to also provide the support 17 to the outer peripheral portion of the upper surface of the bolster plate 2.

In the electronic device 1 according to the third embodiment, a body with elasticity such as a coil spring or a rubber spring may be provided on the upper surface of the bolster plate 2 in place of the disc springs 30. The disc springs 30 may be provided at the same positions where the projections 24 are placed, which have been described in the second embodiment. Alternatively, the disc springs 30 may be provided at positions different from the positions where the projections 24 are placed, which were described in the second embodiment. The positions and number of the disc springs 30 to be placed may be determined depending on the size of the semiconductor package 5. For example, when the size of the semiconductor package 5 is small, one disc spring 30 may be provided on the center portion of the upper surface of the bolster plate 2.

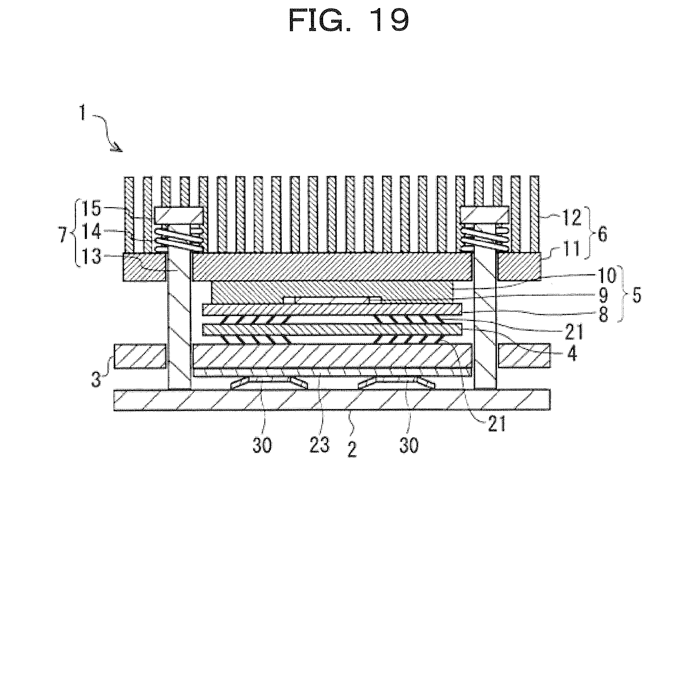

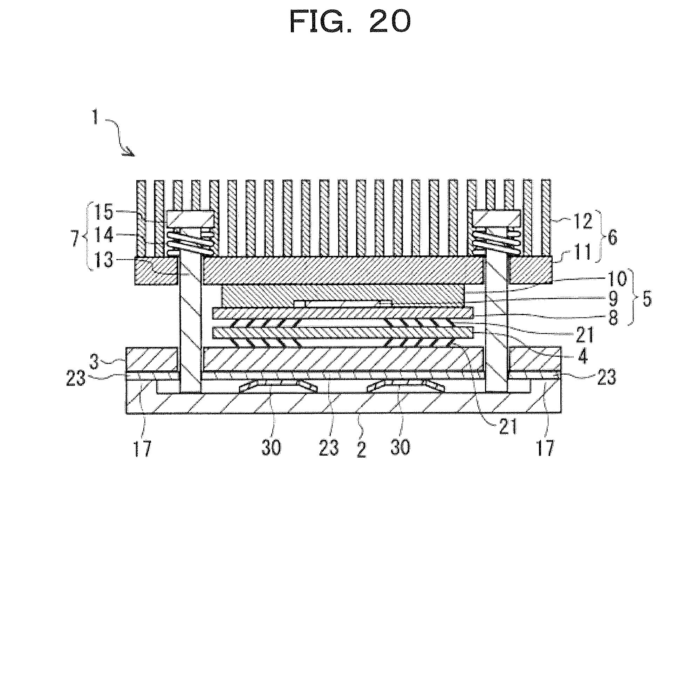

In the electronic device 1 according to the third embodiment, the cover plate (the plate member) 23 may be provided between the bolster plate 2 and the main board 3 as depicted in FIG. 19. That is, the cover plate 23 may be placed above the plurality of disc springs 30. When the main board 3 has a low stiffness, by applying a load from the plurality of disc springs 30 to the main board 3, the main board 3 may be bent. By providing the cover plate 23 between the bolster plate 2 and the main board 3, partial concentration of the load applied from the plurality of disc springs 30 to the main board 3 is suppressed, and bending of the main board 3 may be suppressed. Note that, in the electronic device 1 according to the third embodiment, when the support 17 is provided to the outer peripheral portion of the upper surface of the bolster plate 2, the cover plate 23 may be placed on the support 17 as depicted in FIG. 20.

### [Fourth Embodiment]

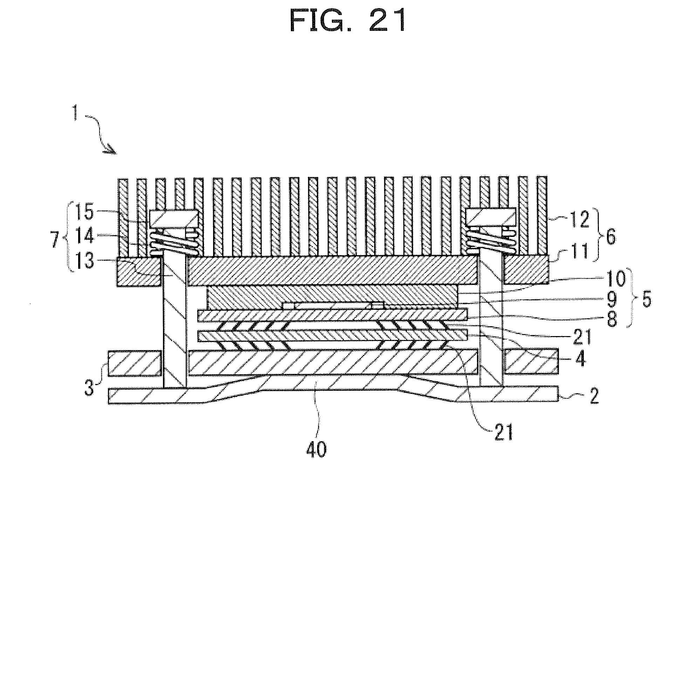

FIG. 21 is a cross-sectional view of the electronic device 1 according to a fourth embodiment. Elements identical to those in the first embodiment are each provided with the same reference numeral as that of the first embodiment and are not described herein. In the electronic device 1 according to the fourth embodiment, the bolster plate 2 is produced in a plate spring shape. That is, a plate spring part 40 is integrally formed as part of the bolster plate 2. The plate spring part 40 is an example of the pressing unit. As depicted in FIG. 21, the main board 3 is placed on the bolster plate 2 that has a plate spring shape. The center portion of the lower surface of the main board 3 and the upper surface of the plate spring part 40 of the bolster plate 2 are in contact with each other. When a load (a pressure) is applied by the fixing unit 7 to the bolster plate 2 and the base plate 11 so as to narrow the space between the bolster plate 2 and the base plate 11, the plate spring part 40 of the bolster plate 2 presses the main board 3 toward the semiconductor package 5. That is, the plate spring part 40 of the bolster plate 2 presses the main board 3 in the direction of the area where the semiconductor package 5 is placed. The plate spring part 40 of the bolster plate 2 is placed below the area where the semiconductor package 5 is placed. Therefore, with the plate spring part 40 of the bolster plate 2 pressing the main board 3 toward the semiconductor package 5, unevenness of the space between the main board 3 and the semiconductor package 5 may be suppressed. As a result, the terminal electrodes of the main board 3 and the pins 21 of the LGA socket 4 are uniformly in contact with each other, and the pins 21 of the LGA socket 4 and the terminal electrodes of the semiconductor package 5 are uniformly in contact with each other, thereby maintaining an electrical connection between the main board 3 and the semiconductor package 5 via the LGA socket 4.

In the electronic device 1 according to the fourth embodiment, since the load is applied from the plate spring part 40 of the bolster plate 2 to the center portion of the lower surface of the main board 3, warping of the semiconductor package 5 is larger, compared with the electronic device 51 according to the comparative example. Therefore, according to the electronic device 1 of the fourth embodiment, unevenness of the space between the semiconductor package 5 and the base plate 11 may be suppressed. That is, according to the electronic device 1 of the fourth embodiment, the ratio of contact between the semiconductor package 5 and the base plate 11 may be increased. As a result, heat transmission from the semiconductor package 5 to the heat sink 6 may be improved, and heat dissipation capability of the semiconductor package 5 may be improved. In addition, when a thermally conductive material is interposed between the semiconductor package 5 and the base plate 11, the ratio of contact between the semiconductor package 5 and the thermally conductive material as well as the ratio of contact between the base plate 11 and the thermally conductive material may be increased. As a result, heat transmission from the semiconductor package 5 to the heat sink 6 may be improved, and the heat dissipation capability of the semiconductor package 5 may be improved.

In the electronic device 1 according to the fourth embodiment, the main board 3 is placed on the bolster plate 2 that is in the plate spring shape, and the center portion of the lower surface of the main board 3 and the upper surface of the plate spring part 40 of the bolster plate 2 are in contact with each other. In the electronic device 1 according to the fourth embodiment, by applying a load from the plate spring part 40 of the bolster plate 2 to the main board 3, the semiconductor package 5 is mounted on the main board 3. With the restoring force of the plate spring part 40 of the bolster plate 2, the main board 3 may be efficiently pressed toward the semiconductor package 5. Therefore, by applying a load from the plate spring part 40 of the bolster plate 2 to the main board 3, a stable electrical connection between the main board 3 and the semiconductor package 5 may be obtained. In addition, since the plate spring part 40 is integrally formed as part of the bolster plate 2, the space where the bolster plate 2 is placed may be decreased, and also the main board 3 may be efficiently pressed toward the semiconductor package 5.

By applying a load from the plate spring part 40 of the bolster plate 2 to the main board 3, the main board 3 may be efficiently pressed toward the semiconductor package 5. Thereby, the support 17 may be omitted from the outer peripheral portion of the upper surface of the bolster plate 2. However, the support 17 may be provided to the outer peripheral portion of the upper surface of the bolster plate 2.

The plate spring part 40 of the bolster plate 2 may be provided at the same position where the projection 16 is placed, which was described in the first embodiment. Alternatively, the plate spring part 40 of the bolster plate 2 may be provided at a position different from the position where the projection 16 is placed, which was described in the first embodiment.

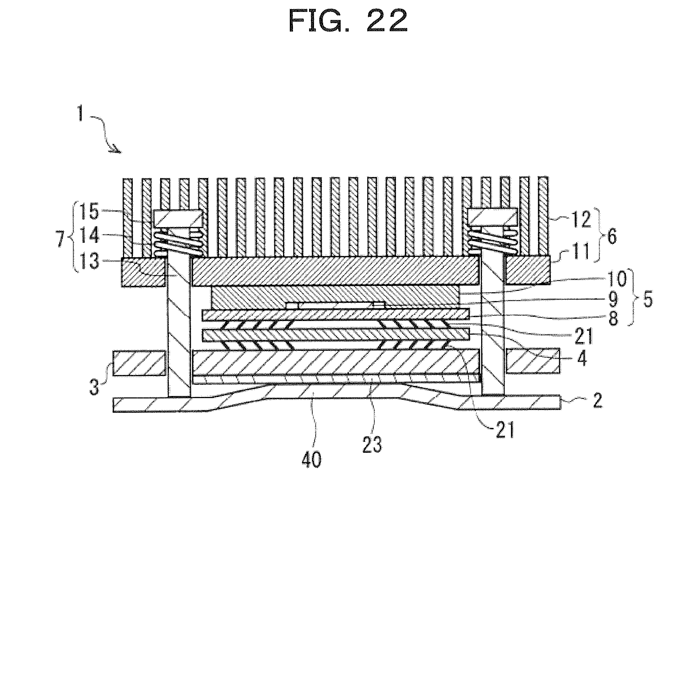

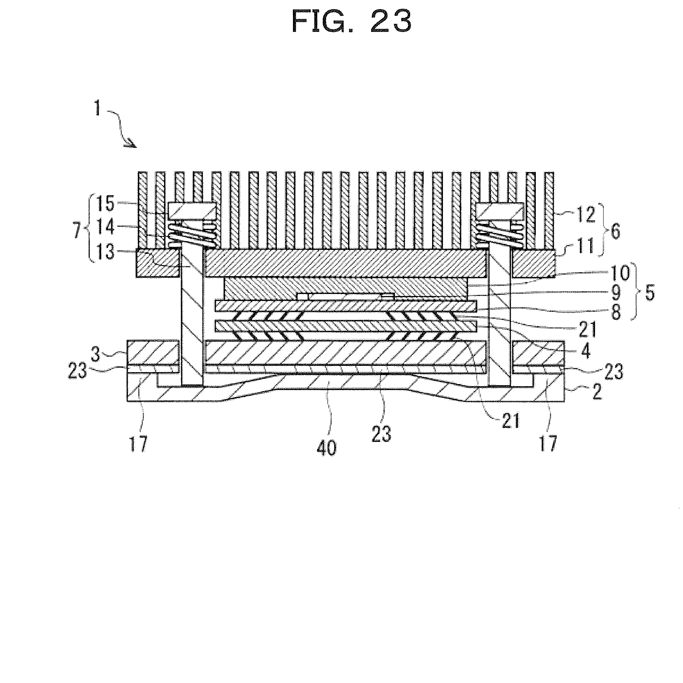

In the electronic device 1 according to the fourth embodiment, the cover plate (the plate member) 23 may be provided between the bolster plate 2 and the main board 3 as depicted in FIG. 22. That is, the cover plate 23 may be placed on the plate spring part 40 of the bolster plate 2. When the main board 3 has a low stiffness, by applying a load from the plate spring part 40 of the bolster plate 2 to the main board 3, the main board 3 may be bent. By providing the cover plate 23 between the bolster plate 2 and the main board 3, partial concentration of the load applied from the plate spring part 40 of the bolster plate 2 to the main board 3 may be suppressed, and bending of the main board 3 may be suppressed. Note that, in the electronic device 1 according to the fourth embodiment, when the support 17 is provided to the outer peripheral portion of the upper surface of the bolster plate 2, the cover plate 23 may be placed on the support 17, as depicted in FIG. 23.

### [Verification]

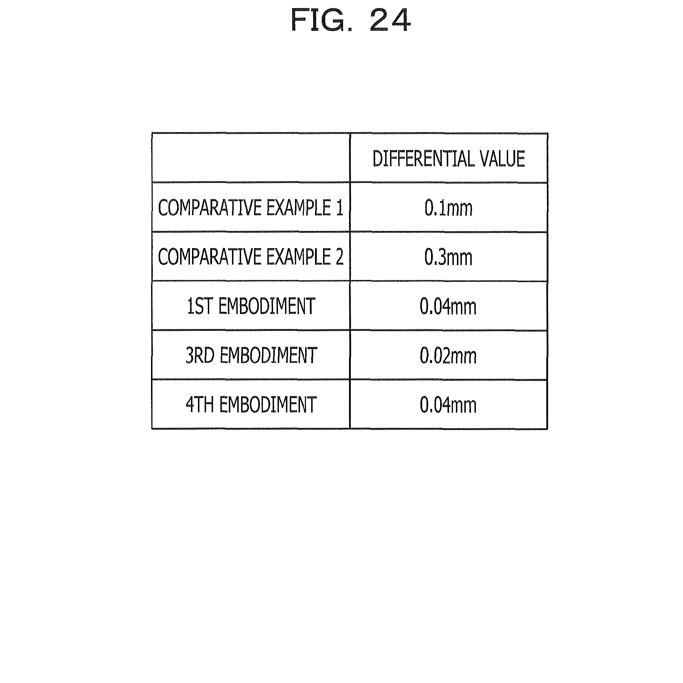

Verification was performed regarding uniformity of the space between the main board 3 and the semiconductor package 5 in the electronic devices 1 according to the first, third, and fourth embodiments. For verification, the size of the semiconductor package 5 for verification was 40 cm², the number of pins 21 of the LGA socket 4 was 3000, and the load that was applied to the main board 3 was 150 kg. In addition, verification was performed regarding uniformity of the space between the main board 52 and the semiconductor package 53 in the electronic device 51 according to the comparative example. For verification, the size of the semiconductor package 53 was 40 cm², the number of pins of the LGA socket 55 was 3000, and the load to be applied to the main board 52 was 150 kg. The verification results are depicted in FIG. 24.

"COMPARATIVE EXAMPLE 1" of FIG. 24 describes the verification result when a standard product of the electronic device 51 according to the comparative example was used for verification. "COMPARATIVE EXAMPLE 2" of FIG. 24 describes the verification result when a product with a bolster plate 54 thinner than the bolster plate 54 of the standard product of the electronic device 51 according to the comparative example was used for verification. "1ST EMBODIMENT" of FIG. 24 describes the verification result when the electronic device 1 of the first embodiment depicted in FIG. 5 was used for verification. "3RD EMBODIMENT" of FIG. 24 describes the verification result when the electronic device 1 of the third embodiment depicted in FIG. 19 was used for verification. "4TH EMBODIMENT" of FIG. 24 describes the verification result when the electronic device 1 of the fourth embodiment depicted in FIG. 22 was used for verification. Regarding "COMPARATIVE EXAMPLE 1" and "COMPARATIVE EXAMPLE 2" of FIG. 24, a numerical value in a field named "DIFFERENTIAL VALUE" was calculated by (maximum value of the space between the main board 52 and the semiconductor package 53) - (minimum value of the space between the main board 52 and the semiconductor package 53). Regarding "1ST EMBODIMENT", "3RD EMBODIMENT", and "4TH EMBODIMENT", a numerical value in the field named "DIFFERENTIAL VALUE" is calculated by (maximum value of the space between the main board 3 and the semiconductor package 5) - (minimum value of the space between the main board 3 and the semiconductor package 5).

As depicted in FIG. 24, it may be found that unevenness of the space between the main board 3 and the semiconductor package 5 is suppressed in the electronic devices 1 according to the first, third, and fourth embodiments, compared with the electronic device 51 according to the comparative example. The electronic device 1 according to the second embodiment produces an approximately equal result as that of the electronic device 1 according to the first embodiment and therefore the verification result of the second embodiment is not described in FIG. 24.

Verification was performed for the uniformity of the space between the semiconductor package 5 and the base plate 11 in the electronic device 1 according to the third embodiment. For verification, the size of the semiconductor package 5 was 40 cm², the number of pins 21 of the LGA socket 4 was 3000, and the load to be applied to the main board 3 was 150 kg. In addition, verification was performed for the uniformity of the space between the semiconductor package 53 and the base plate 58 in the electronic device 51 according to the comparative example. For verification, the size of the semiconductor package 53 was set at 40 cm², the number of pins of the LGA socket 55 was 3000, and the load to be applied to the main board 52 was 150 kg.

For the electronic device 1 according to the third embodiment, the electronic device 1 of the third embodiment depicted in FIG. 19 was used for verification. For the electronic device 51 according to the comparative example, a standard product was used for verification. For the electronic device 1 according to the third embodiment, the verification result was 0.05 mm. For the electronic device 51 according to the comparative example, the verification result was 0.15 mm. The numerical value of the verification result for the third embodiment was calculated by (maximum value of the space between the semiconductor package 5 and the base plate 11) - (minimum value of the space between the semiconductor package 5 and the base plate 11). The numerical value of the verification result regarding the comparative example was calculated by (maximum value of the space between the semiconductor package 53 and the base plate 58) - (minimum value of the space between the semiconductor package 53 and the base plate 58). As such, it may be found that unevenness of the space between the semiconductor package 5 and the base plate 11 is more suppressed in the electronic device 1 according to the third embodiment, compared with the electronic device 51 according to the comparative example.

Since the size of a semiconductor package 5 tends to be increasing and the number of terminal electrodes on the semiconductor package 5 tends to be increasing, the load to mount the semiconductor package 5 onto the main board 3 is increasing. According to the electronic devices 1 of the first to fourth embodiments, even if the load to mount the semiconductor package 5 on the main board 3 has increased, unevenness of the space between the main board 3 and the semiconductor package 5 may be suppressed. In addition, according to the electronic devices 1 of the first to fourth embodiments, even if the load to mount the semiconductor package 5 on the main board 3 has increased, unevenness of the space between the semiconductor package 5 and the base plate 11 may be suppressed.

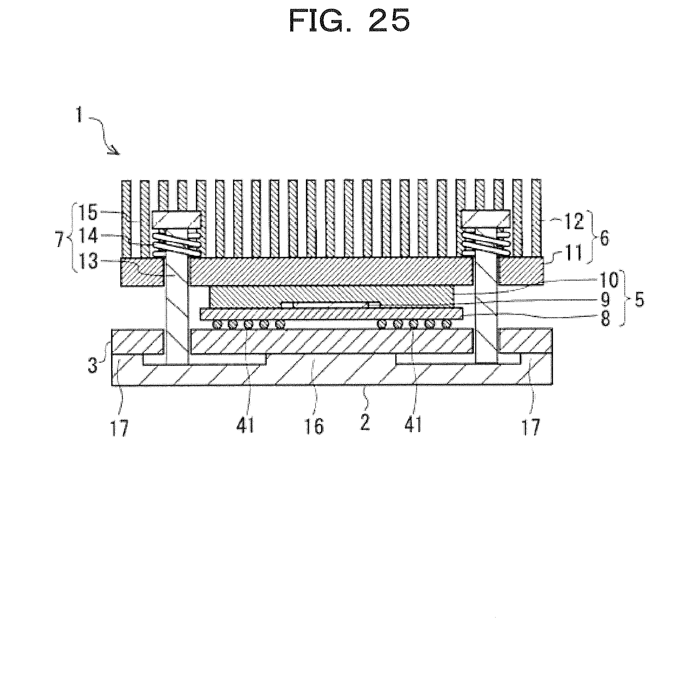

In the first to fourth embodiments, an example was described in which the semiconductor package 5 was mounted on the main board 3 with the LGA mounting methodology. In the first to fourth embodiments, in place of the LGA mounting methodology, the BGA mounting methodology may be used to mount the semiconductor package 5 on the main board 3. That is, the electronic devices 1 according to the first to fourth embodiments may be manufactured to use the BGA mounting methodology to mount the semiconductor package on the main board 3. FIG. 25 is a cross-sectional view of the electronic device 1 when the semiconductor package 5 is mounted on the main board 3 with the BGA mounting methodology in the first embodiment. As depicted in FIG. 25, solder balls 41 are placed on the lower surface of the semiconductor package 5. The solder balls 41 are an example of the connecting unit. The solder balls 41 and terminal electrodes provided to the lower surface of the semiconductor package 5 are bonded to each other. The bonding between the terminal electrodes provided to the lower surface of the semiconductor package 5 and the solder balls 41 are performed by melting the solder balls 41 with a reflow process. The terminal electrodes of the main board 3 and the solder balls 41 are bonded to each other. The bonding between the terminal electrodes of the main board 3 and the solder balls 41 are performed by melting the solder balls 41 with a reflow process. The solder balls 41 electrically couple the terminal electrodes of the main board 3 and the terminal electrodes of the semiconductor package 5 to each other. As a result, the main board 3 and the semiconductor package 5 are electrically coupled to each other via the solder balls 41.

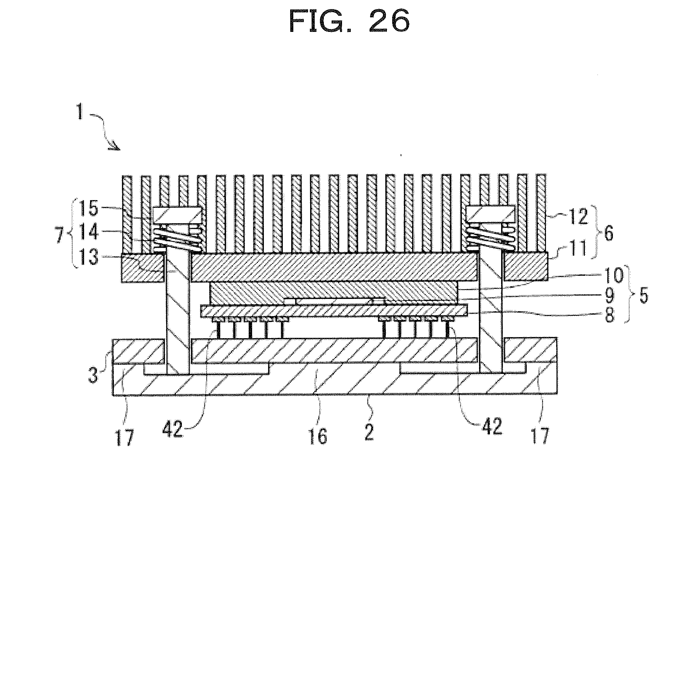

In addition, in the first to fourth embodiments, in place of the LGA mounting methodology, the PGA mounting methodology may be used to mount the semiconductor package 5 on the main board 3. That is, the electronic devices 1 according to the first to fourth embodiments may be manufactured to use the PGA mounting methodology to mount the semiconductor package on the main board 3. FIG. 26 is a cross-sectional view of the electronic device 1 when the semiconductor package 5 is mounted on the main board 3 with the PGA mounting methodology in the first embodiment. As depicted in FIG. 26, pins 42 are placed on the lower surface of the semiconductor package 5. The pins 42 are an example of the connecting unit. One ends of the pins 42 are coupled to the terminal electrodes provided to the lower surface of the semiconductor package 5. The other ends of the pins 42 are in contact with the terminal electrodes of the main board 3. The pins 42 electrically couple the terminal electrodes of the main board 3 and the terminal electrodes of the semiconductor package 5 to each other. As a result, the main board 3 and the semiconductor package 5 are electrically coupled to each other via the pins 42.

In the first to fourth embodiments, an example has been described in which the semiconductor package 5 is mounted on the main board 3. This is not meant to be restrictive, and the first to fourth embodiments may be applied when the semiconductor chip 9 is mounted on the main board 3. For example, in place of the semiconductor package 5, the semiconductor chip 9 may be mounted on the main board 3, and the heat sink 6 may be placed on the semiconductor chip 9. In this case, a thermally conductive material such as aluminum, copper, or aluminum nitride may be interposed between the heat sink 6 and the semiconductor chip 9. In the first to fourth embodiments, an example has been described in which four support shafts 13 are placed on the bolster plate 2. However, in the first to fourth embodiments, the number of support shafts 13 to be placed is not restricted to four. For example, in the first to fourth embodiments, the number of support shafts 13 to be placed may be two. The structures of the electronic devices 1 according to the first to fourth embodiments may be combined as much as possible.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. An electronic device comprising:
a first plate;
a wiring board arranged on the first plate and configured to have a plurality of first terminals on a surface opposite to a surface facing the first plate;
an electronic component arranged above the wiring board and configured to have a plurality of second terminals on a surface facing the wiring board;
a connecting unit arranged between the wiring board and the electronic component and configured to electrically couple the first terminals and the second terminals;
a second plate arranged on the electronic component;
a fixing unit arranged in an area outside of an area where the electronic component is placed and configured to pressurize the first plate and the second plate so that narrow a space between the first plate and the second plate; and
a pressing unit arranged below the area where the electronic component is placed and configured to press the wiring board toward the electronic component.

2. The electronic device according to claim 1, wherein
the pressing unit is a protrusion provided on the first plate between the first plate and the wiring board.

3. The electronic device according to claim 1, wherein
the pressing unit is an elastic body provided on the first plate between the first plate and the wiring board.

4. The electronic device according to claim 1, wherein
the pressing unit is a plate spring part integrally formed on the first plate.

5. The electronic device according to claim 1, further comprising
a support member is provided in the perimeter portion of the first plate so as to press the wiring board toward the electronic component.

6. The electronic device according to claim 5, further comprising
plate members are provided between the first plate and the pressing unit and between the first plate and the support member.

7. The electronic device according to claim 1, further comprising
a plate member is provided between the first plate and the pressing unit.
